# FASCICULE DE BREVET EUROPEEN

(11) **EP 0 601 901 B1**
(45) Date de publication et mention de la délivrance du brevet: **02.02.2000**
(21) Numéro de dépôt: 93402671.7
(22) Date de dépôt: 29.10.1993
(51) Int. Cl.: H01L 21/331, H01L 21/28, H01L 21/306

(54) **Procédé de gravure d'une hétérostructure de matériaux du groupe III-V**
Ätzverfahren für Heterostrukturen aus Materialien der III-V Gruppe
Etching method for heterostructure of III-V compound material

(30) Priorité: 06.11.1992 FR 9213400
(43) Date de publication de la demande: 15.06.1994
(73) Titulaire: THOMSON-CSF, 75008 Paris (FR)
(72) Inventeur: Delage, Sylvain, Thomson-CSF, F-92402 Courbevoie Cédex (FR); Blanck, Hervé, Thomson-CSF, F-92402 Courbevoie Cédex (FR); Cassette, Simone Thomson-CSF, F-92402 Courbevoie Cédex (FR)

(56) Documents cités:
- EP-A- 0 408 252
- EP-A- 0 480 803
- US-A- 5 111 265
- APPLIED PHYSICS LETTERS., vol.53, no.11, 12 Septembre 1988, NEW YORK US pages 983 - 985 W. T. TSANG ET AL
- IEEE ELECTRON DEVICE LETTERS., vol.EDL-7, no.6, Juin 1986, NEW YORK US pages 359 - 362 R. FISCHER ET AL
- PROCEEDING OF THE INTER. ELECTRON DEVICES MEETING 1987;, 6 Décembre 1987, WASHINGTON, D.C. pages 852 - 853 H. SCHUMACHER ET AL

## Description

La présente invention concerne un procédé de réalisation des métallisations d'un transistor à structure verticale, présentant un motif en relief dit mésa : le dépôt des métallisations sur et autour du mésa doit respecter les flancs verticaux du motif pour éviter un court-circuit dû à des dépôts métalliques parasites.

Le procédé selon l'invention s'applique de préférence aux composants verticaux du groupe III-V, et plus particulièrement aux transistors bipolaires à hétérojonction TBH (ou HBT en anglais) dans lesquels le courant est transporté perpendiculairement à la surface du substrat : il y a donc au moins une métallisation d'électrode d'accès - l'émetteur - sur le mésa, et une métallisation d'électrode de commande -la base- au pied du mésa, la seconde métallisation d'accès - le collecteur - étant dans un troisième plan, soit au dos du substrat, soit au fond d'une gravure. Le bon fonctionnement de ces transistors, qui sont destinés aux hyperfréquences, rend nécessaire de:
- diminuer au maximum la surface de la jonction base-collecteur,
- éviter des courts-circuits entre émetteur et base,
- limiter l'interaction entre la base du transistor et l'hydrogène provenant du plasma de gravure.

Certains transistors à effet de champ, bien que le courant s'y écoule parallèlement à la surface du substrat, par exemple les SISFETs (Semiconductor-Insulator-Semiconductor Field Effect Transistor), peuvent être considérés comme des composants verticaux, dans la mesure où ils comportent un motif semiconducteur gravé qui sert à autoaligner deux métallisations l'une par rapport à l'autre.

En outre, le procédé selon l'invention est destiné plus particulièrement aux transistors de puissance dans lesquels la température de fonctionnement peut atteindre 200°C, ce qui nécessite donc une très grande stabilité thermique du dispositif.

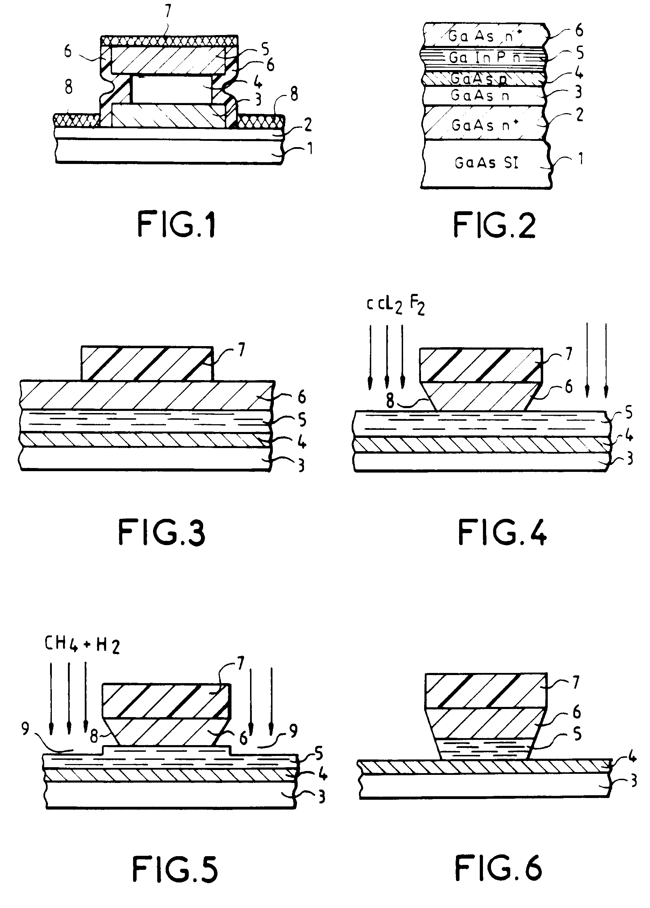

Un procédé de réalisation des métallisations d'un transistor vertical de type HBT est déjà décrit dans la demande de brevet français n° 90 12442, déposée le 9 octobre 1990 par la Demanderesse. Ce procédé est brièvement rappelé par la figure 1.

Le transistor décrit sur cette figure comporte :
- un substrat 1, dopé n, qui sert de collecteur,
- une couche 2, dopée p⁺, qui constitue la base,
- une couche 3, dopée n, qui est l'émetteur, recouvert par une couche 4 dopée n⁺ pour améliorer le contact ohmique avec la métallisation 5 d'émetteur.

Les matériaux de ces couches sont tous du groupe III-V, mais ceux des deux couches 3 et 4 sont choisis - GaInP pour la couche 3 et GaAs pour la couche 4, par exemple - de façon à présenter une réaction différente à deux procédés de gravure différents; par exemple, la gravure du mésa 3+4+5 se fait par une première gravure ionique réactive RIE de composés chlorés en présence d'hélium, tandis qu'une seconde gravure RIE par le méthane en présence d'hydrogène crée une sous-gravure de la couche 4 de contact sous la métallisation 5.

L'ensemble est alors recouvert par une couche 6+7+8 d'un diélectrique dont les parties 6 présentent une cavité qui pénètre dans la sous-gravure de la couche 4. Cette cavité interrompera, ultérieurement, les métallisations parasites qui se déposent sur les flancs du mésa, et qui court-circuitent émetteur et base. Par une troisième gravure ionique à l'héxafluorure de soufre, les parties 7 et 8 du diélectrique, déposées à l'emplacement des métallisations d'émetteur et de base, sont supprimées : une évaporation de métaux déposera en 8 le contact de base, et renforcera en 7 le contact d'émetteur.

Ce procédé est efficace, mais il utilise trois gravures ioniques réactives : pour faire passer les transistors HBT en fabrication industrielle, il est plus intéressant de mettre en oeuvre des moyens technologiques plus simples, moins chers et par conséquent plus économiques pour le produit final.

Le procédé selon l'invention utilise un phénomène électrochimique spécifique, qui impose qu'une couche de matériau semiconducteur contienne du phosphore, par exemple dans Ga InP, et une autre couche sous-jacente contienne de l'arsenic, par exemple dans GaAs.

L'attaque chimique de la couche contenant P, par une solution acide, est bloquée par la couche contenant As. Cette attaque chimique peut n'être possible qu'après avoir été amorcée par une légère gravure ionique de la surface supérieure de la couche contenant P, en raison d'interdiffusions qui font que les propriétés physico-chimiques de la dite surface ne permettent pas une attaque chimique directe.

De façon plus précise, l'invention concerne un procédé de gravure d'une hétérostructure de couches de matériaux semiconducteurs du groupe III-V, pour la réalisation d'un transistor à hétérojonction, ce procédé étant caractérisé en ce que l'hétérojonction comprend au moins une première couche d'un composé comportant de l'arsenic (GaAs, AlGaAs...) qui est gravée par une première gravure ionique réactive, et une deuxième couche d'un composé comportant du phosphore (InP, GaInP...) qui est gravée par une solution aqueuse d'acide chlorhydrique HCl.

L'invention sera mieux comprise par la description qui suit d'un exemple d'application, faite en s'appuyant sur les figures jointes en annexe, qui représentent :
- figure 1 : schéma de principe d'un procédé selon l'art connu, précédemment exposé,
- figures 2 à 9 : différentes étapes du procédé selon l'invention.

L'invention sera plus aisément décrite au moyen de l'exemple d'un transistor vertical HBT npn associant le couple de matériaux GaInP/GaAs, mais cet exemple ne constitue nullement une limitation à l'invention : l'un des deux matériaux doit contenir P (InP,GaP,...) et l'autre matériau doit contenir As (GaInAs, GaAlAs,...) de façon à créer un couple de matériaux qui réagissent de façon différente vis à vis d'un couple de procédés de gravure.

La figure 2 représente une coupe de la structure épitaxiale de départ dans laquelle sera réalisé un transistor HBT.
Cette structure comprend, par exemple :
- un substrat 1 en GaAs semi-isolant,
- un sous collecteur 2 en GaAs fortement dopé de type n,
- un collecteur 3 en GaAs moyennement dopé n,
- une base 4 en GaAs dopée p⁺ d'une épaisseur comprise de 30 à 120 nm,
- un émetteur 5 en GaInP dopé n,
- une couche de contact 6 en GaAs fortement dopé n⁺, pouvant contenir du GaInAs.

Afin de simplifier les figures suivantes (3 à 6), celles-ci ne représentent pas le substrat 1 et le sous-collecteur 2 si leur présence n'est pas utile à la compréhension de l'invention.

La première étape technologique (figure 3) consiste à réaliser un émetteur virtuel 7. Ce masque peut être réalisé soit à l'aide d'un isolant de type nitrure ou de polymères photosensibles, soit de tout autre matériau tel que du germanium, du titane, de l'aluminium ou d'un alliage Au-Ge/Ni/Au. L'intérêt de cette approche est de permettre d'utiliser des techniques de gravure directe du masque, ou bien d'utiliser une technique de pelage du type lift-off.

La seconde étape, représentée en figure 4, consiste à graver par voie sèche le GaAs n⁺ de la couche de contact 6, anisotropiquement et sélectivement par rapport au GaInP de la couche d'émetteur 5. On peut de plus créer une légère sous-gravure latérale 8 évitant tout risque de dépôts métalliques ultérieurs sur les flancs du motif 6+7 en prolongeant l'attaque. Pour le couple de matériaux GaAs/GaInP, la gravure ionique sélective du GaAs est réalisée par exemple en utilisant les gaz réactifs CCl₂F₂ ou SiCl₄, ce qui permet une sélectivité quasiment infinie par rapport à GaInP et un contrôle très précis de la gravure latérale.

Les étapes suivantes sont représentées en partie sur la figure 5 et en partie sur la figure 6 : elles consistent à graver la couche 5 de l'émetteur de GaInP par autoalignement sur le motif 6 de prise de contact, en GaAs. L'acide chlorhy drique attaque fortement le GaInP mais n'attaque pas le GaAs.

Mais en fait, après la gravure ionique réactive, l'interface des couches 5/6 GaInP/GaAs présente des propriétés physico-chimiques mal connues, qui ne permettent pas parfois l'attaque de GaInP par HCl, directement. On pense que des interdiffusions sont peut-être quelquefois présentes entre ces deux couches. C'est pourquoi il est peut - être nécessaire d'éliminer d'abord (figure 5) une pellicule superficielle 9 dans la couche 5 de GaInP par gravure ionique réactive par CH₄ et H₂ ou par bombardement ionique, sur une épaisseur d'environ 100 nm. La sélectivité d'attaque - de l'ordre de 4 - de GaInP par CH₄ + H₂, par rapport à GaAs, permet de minimiser les risques d'attaque de la base 4. De plus, l'attaque partielle de Ga InP par CH₄ + H₂ évite les problèmes de passivation de la base 4 par l'hydrogène atomique issu du plasma.

Après ce décapage superficiel de la couche 5 de GaInP, on peut alors procéder à la gravure à proprement parler de l'émetteur, par dissolution de GaInP dans une solution aqueuse acide chlorhydrique, qui n'attaque pas GaAs. La figure 6 représente le produit à la fin de cette étape : la gravure par HCl ne modifie pas la couche de contact 6 qui est en GaAs n⁺ , et elle vient buter contre la couche de base 4 également en GaAs p⁺. Par contre, cette attaque a sous-gravé la couche d'émetteur 5, qui est autoalignée sur la couche de contact 6.

L'attaque chimique sélective par HCl révèle des plans cristallins, dont il faut tenir compte au moment de l'implantation d'un circuit sur la plaquette épitaxiée de la figure 2.

La cinquième étape, qui n'est pas représentée, consiste à retirer le masque de gravure 7, qui a servi d'émetteur virtuel pour l'autoalignement. Cela peut être effectué par voie humide ou sèche, et de façon sélective, par l'un des nombreux moyens connus de l'homme de l'art.

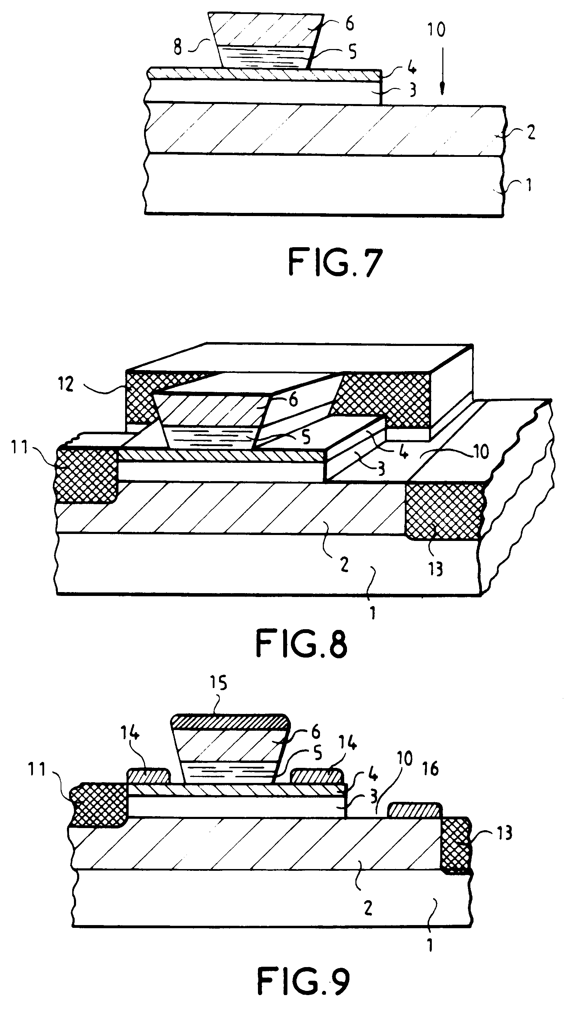

Les métallisations d'émetteur et de base pourraient être maintenant déposées respectivement sur les couches 6 et 4, mais il faut d'abord compléter le transistor par un collecteur et éventuellement des caissons isolants. En figure 7, les couches 4 de base et 3 de collecteur sont gravées, par voie sèche ou humide, en une région 10 voisine du pied du mésa 5 + 6. C'est dans cette région 10 que sera déposée la métallisation de collecteur, sur la couche 2 très dopée n⁺. Mais si le substrat 1 est dopé au lieu d'être semi-isolant, la métallisation de collecteur peut être portée par la face arrière du substrat 1, et la gravure latérale des couches 3 et 4 n'est plus nécessaire : cette variante ne sort pas du domaine de l'invention

La septième étape consiste à réaliser l'implantation ionique d'isolation électrique dans les différents parties du dispositif afin de permettre la réduction des différents parasites néfastes aux performances hyperfréquences du composant, tout particulièrement sous les futurs plots émetteur et base permettant la connexion par ponts-à-air. La figure 8, qui est une vue de trois-quart dans l'espace, montre qu'une partie des couches 2+3+4, au pied du mésa 5+6, est rendue isolante par implantation et forme un caisson 11, implanté là où nécessaire pour isoler le transistor de ses voisins.

Cette même figure 8 montre que le mésa de l'émetteur est en fait en forme de Té, dont une partie 12 est implantée : c'est cette partie qui supportera la métallisation d'émetteur dans la région où elle reçoit une connexion externe telle qu'un pont à air.

De surcroît , il est possible de rendre semi-isolant le matériau du sous-collecteur 2 entre les composants par implantation de caissons tels que 13. Cela permet à la fois de limiter la marche à franchir par les ponts-à-air et élimine une étape de gravure.

La dernière étape consiste à réaliser les contacts ohmiques émetteur, base et collecteur. Dans le cas de la couche 4 de base en GaAs p+, la prise de contact ohmique 14 (figure 9) peut être effectuée de façon excellente à l'aide de contacts non alliés. La présence de GaInAs n+ en couche 6 permet aussi la réalisation de contacts ohmiques de type n de qualité satisfaisante sans alliage. Il est donc aisé, en ce cas, de réaliser en une seule étape le contact ohmique de l'émetteur en 15 et de la base en 14 soit à l'aide de matériaux complètement réfractaires (W, Mo, TiWSi), soit en utilisant des contacts non alliés plus classiques contenant de l'or ou d'autres métaux connus pour leur bonne résistivité électrique (Al par exemple) : de tels contacts peuvent être du type Ti/Pt/Au, Ti/Au, Ti/Al, Mo/Au... La possibilité d'utiliser des réfractaires, ou des combinaisons de métaux réfractaires et de métaux tels que or et aluminium permet à la fois d'obtenir des contacts parfaitement stables thermiquement et d'éviter de recourir à des techniques de pelage (lift-off).

Dans le cas de structures de matériaux spécifiques, le contact collecteur 16 peut être réalisé dans le même temps en utilisant le même dépôt métallique, ou bien encore, si un contact non allié s'avère difficile à réaliser, par recours à un contact allié plus classique à base d'or, de germanium, et de nickel par exemple.

La présente invention, reposant essentiellement sur les propriétés de l'hétérostructure GaInP/GaAs, présente tous les avantages de l'autoalignement, mais aussi permet à la fois :
- contrôler la géométrie de l'émetteur déterminée par la lithographie et par une attaque sèche anisotrope précise,
- de limiter les risques de passivation électrique des dopants de la base par l'hydrogène atomique généré par les plasmas de gravure,
- de limiter les recuits nécessaires à la réactivation du dopant de la base se produisant lors d'une gravure RIE contenant de l'hydrogène atomique.
- d'optimiser la résistance d'accès de l'émetteur,
- de contrôler l'arrêt de l'attaque sur la base à quelques couches atomiques près,
- de donner à l'isolant un rôle plus proche de la passivation électrique que celui de "side-wall" qui nécessite de cumuler des fonctions de passivation, d'isolant, de tenue aux acides... et d'autre part permet :
- d'éliminer une étape critique du type lift-off (amélioration des procédés),
- d'effectuer la gravure du mésa de l'émetteur en utilisant un masque non métallique (diminution des taux de défauts sur plaque et donc amélioration du rendement de fabrication),
- d'utiliser des métallisations en matériaux réfractaires (stabilité thermique et amélioration de la fiabilité),
- de réaliser en une seule étape les contacts ohmiques de l'émetteur et de la base, et potentiellement, celui du collecteur. (diminution du nombre d'étapes, et donc diminution des coûts de fabrication et des risques liés aux manipulations).

Le procédé selon l'invention a été exposé en s'appuyant sur l'exemple du couple de matériaux GaInP/GaAs : il est plus généralement applicable à d'autres couples de matériaux parmi lesquels l'un contient du phosphore et l'autre contient de l'arsénic.

Ce procédé est également applicable à d'autres transistors que les transistors de type HBT. Il est précisé par les revendications suivantes.

## Revendications

1. Procédé de gravure d'une hétérostructure de couches de matériaux semiconducteurs du groupe III-V, pour la réalisation d'un transistor à hétérojonction, ladite hétérostructure comportant une première couche (6) d'un premier composé comportant de l'arsenic (GaAs, AlGaAs), déposée sur une deuxième couche (5) d'un second composé comportant du phosphore (InP, GaInP), les premier et second composés créant un couple de matériaux réagissant de façon différente vis-à-vis d'un couple de procédés de gravure dans lequel la première couche (6) est gravée par une première gravure ionique réactive et la seconde couche (5) est gravée de manière à autoaligner ladite deuxième couche (5) sur ladite première couche (6) et caractérisé en ce que la deuxième couche est gravée par une solution aqueuse d'acide chlorhydrique HCl et en ce que l'attache chimique HCl de la deuxième couche (5) est précédée d'un décapage de surface par une deuxième gravure ionique réactive, localisée sur une épaisseur de l'ordre de 100nm (1000 Angströms), ce décapage étant rendu nécessaire par la présence d'interdiffusions à l'interface de la première (6) et de la deuxième (5) couches.

2. Procédé de gravure selon la revendication 1, caractérisé en ce que la première couche (6) est gravée par un plasma de CCl₂ F₂ ou de Si Cl₄.

3. Procédé de gravure selon la revendication 1, caractérisé en ce que la deuxième couche (5) est partiellement gravée par un plasma de CH₄ + H₂ ou par bombardement ionique à faible énergie.

## Claims

1. Process for etching a heterostructure of layers of group III-V semiconductor materials, for producing a heterojunction transistor, said heterostructure including a first layer (6) of a first compound containing arsenic (GaAs, AlGaAs) deposited on a second layer (5) of a second compound containing phosphorus (InP, GaInP), the first and second compounds creating a pair of materials which react differently with respect to a pair of etching processes in which the first layer (6) is etched by a first reactive ion etching and the second layer (5) is etched so as to self-align said second layer (5) on said first layer (6), and characterised in that the second layer is etched by an aqueous solution of hydrochloric acid HCl and in that the chemical attack by HCl on the second layer (5) is preceded by a cleansing of the surface by means of a second reactive ion etching, localised on a thickness of the order of 100 nm (1000 angstroms), this cleansing being necessitated by the presence of interdiffusions at the interface of the first (6) and second (5) layers.

2. Etching process according to claim 1, characterised in that the first layer (6) is etched by a plasma of CCl₂F₂ or SiCl₄.

3. Etching process according to claim 1, characterised in that the second layer (5) is partially etched with a plasma of CH₄ + H₂ or by low-energy ion bombardment.

## Patentansprüche

1. Verfahren zur Ätzung einer Heterostruktur von Halbleitermaterialien der Gruppe III-V für die Herstellung eines Heterojunktionstransistors, wobei die Heterostruktur eine erste Schicht (6) aus einer Arsen enthaltenden ersten Verbindung (GaAs, AlGaAs) enthält, die auf eine zweite Schicht (5) aus einer Phosphor enthaltenden zweiten Verbindung (InP, GaInP) aufgebracht wird, wobei die erste und die zweite Verbindung ein Paar von unterschiedlich auf zwei Ätzverfahren reagierende Materialien bilden und wobei die erste Schicht (6) durch eine erste reaktive Ionenätzung und die zweite Schicht (5) so graviert wird, daß sie sich zur ersten Schicht (6) selbsttätig ausrichtet, dadurch gekennzeichnet, daß die zweite Schicht (5) mit einer wässrigen Lösung von Salzsäure HCl geätzt wird und daß dem chemischen Ätzen der zweiten Schicht (5) mit HCl ein Abbeizen der Oberfläche durch eine zweite reaktive Ionenätzung, beschränkt auf eine Dicke von etwa 100 nm (1000 Å), vorausgeht, wobei dieses Abbeizen wegen der Interdiffusionen an der Übergangsfläche zwischen der ersten Schicht (6) und der zweiten Schicht (5) erforderlich wird.

2. Ätzverfahren nach Anspruch 1, dadurch gekennzeichnet, daß die erste Schicht (6) mit einem Plasma von CCl₂F₂ oder von SiCl₄ geätzt wird.

3. Ätzverfahren nach Anspruch 1, dadurch gekennzeichnet, daß die zweite Schicht (5) teilweise durch ein Plasma von CH₄ und H₂ oder durch Ionenbeschuß mit geringer Energie geätzt wird.
